# EUROPEAN PATENT APPLICATION

(11) **EP 0 884 779 A2**
(43) Date of publication of application: **16.12.1998**
(21) Application number: 98110205.6
(22) Date of filing: 04.06.1998
(51) Int. Cl.: H01L 23/495

(54) **Structure of bonding an inner lead to an electrode in a semiconductor device**

(30) Priority: 09.06.1997 JP 151234/97
(71) Applicant: NEC CORPORATION, Tokyo (JP)
(72) Inventor: Endou, Hirotaka, Minato-ku, Tokyo (JP)
(74) Representative: Betten & Resch

(57) **Abstract**

There is provided a semiconductor device including a semiconductor substrate (2), at least one electrode (3, 3a) formed on the semiconductor substrate (2), and an inner lead (6) bonded to the electrode (3, 3a), characterized by that the inner lead (6) is bonded to the electrode (3, 3a) at a plurality of bonding points (5, 5a). For instance, the electrode (3) is shaped a rectangle having a longer side perpendicular to an edge of the semiconductor substrate (2), and the bonding points (5) are arranged in a longitudinal direction of the electrode (3). As an alternative, the electrode (3a) may be shaped a square, in which case, the bonding points (5a) are arranged in a grid. The above-mentioned semiconductor device provides a greater bonding area than a bonding area provided by a single bonding point, which ensures greater bonding strength.

## Description

### BACKGROUND OF THE INVENTION

### FIELD OF THE INVENTION

The invention relates to a semiconductor device, and more particularly to a structure of bonding an inner lead to an electrode formed on a semiconductor substrate.

### DESCRIPTION OF THE PRIOR ART

When an inner lead is bonded to an electrode, as suggested in Japanese Unexamined Patent Publication No. 2-181453, an inner lead of TAB tape is bonded to a rectangular or square electrode by thermocompression bonding or through bumps. In addition, an inner lead is bonded to an electrode generally at a single bonding point, as suggested in Japanese Unexamined Patent Publication No. 2-28933.

In these days, a rectangular electrode having a width of about 60 µm and a length in the range of 200 µm to 240 µm has been put to practical use. The rectangular electrode has a longer side extending perpendicularly to an edge of a semiconductor substrate. An inner lead is bonded to the rectangular electrode in a longitudinal direction of the rectangular electrode through bumps or by thermocompression bonding by means of a bonding tool.

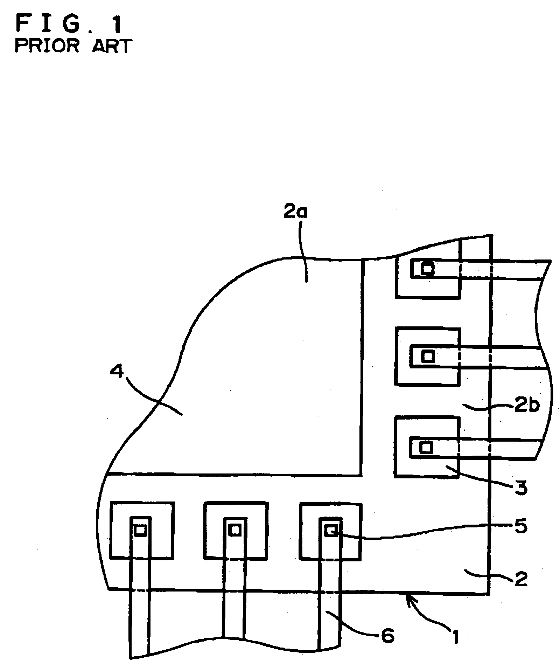

Fig. 1 illustrates a conventional semiconductor device. The illustrated semiconductor device 1 includes a semiconductor substrate 2 having a central area 2a in which an integrated circuit 4 is formed, and a marginal area 2b around the central area 2a. In the marginal area 2b, a plurality of electrodes 3 are formed in a line. The electrodes 3 are all square in shape. Inner leads 6 are bonded to the electrodes 3 at a center of the electrodes 3.

As illustrated in Fig. 1, each of the inner leads 6 is bonded to each of the electrodes 3 at a single bonding point 5.

A bonding area at which an inner lead is bonded to an electrode is generally a square or a circle having a side or a diameter of about 40 µm. Thus, an inner lead is bonded to an electrode through a bonding area which is small relative to an area of an electrode. Hence, a bonding strength of a bonding between an inner lead and an electrode is relatively small, which often causes a problem that an inner lead of TAB tape is readily peeled off an electrode. This is because an inner lead is bonded to an electrode at a single bonding point with the result of a small bonding area and hence a small bonding strength.

### SUMMARY OF THE INVENTION

It is an object of the present invention to provide a semiconductor device which provides an enhanced bonding strength between an inner lead of TAB tape and an electrode. It is also an object of the present invention to provide a method of bonding an inner lead to an electrode, which method provides an enhanced bonding strength between an inner lead of TAB tape and an electrode.

In one aspect of the present invention, there is provided a semiconductor device including a semiconductor substrate, at least one electrode formed on the semiconductor substrate, and an inner lead bonded to the electrode, characterized by that the inner lead is bonded to the electrode at a plurality of bonding points.

It is preferable that the electrode is shaped a rectangle having a longer side perpendicular to an edge of the semiconductor substrate, in which case, the bonding points are arranged in a longitudinal direction of the electrode. The bonding points are preferably equally spaced away from adjacent ones.

The electrode may be shaped a square, in which case, the bonding points are arranged in a grid.

There is further provided a structure of bonding an inner lead to an electrode formed on a semiconductor substrate, characterized by a plurality of bonding points at which the inner lead is bonded to the electrode.

In another aspect of the present invention, there is provided a method of bonding an inner lead to an electrode in a semiconductor device, characterized by the step of bonding an inner lead to an electrode at a plurality of bonding points.

There is further provided a method of bonding an inner lead to an electrode in a semiconductor device, characterized by the step of bonding an inner lead to a square electrode at a plurality of bonding points arranged in a grid.

In accordance with the above-mentioned semiconductor device or method, a bonding area at which an inner lead is bonded to an electrode is increased relative to that of a single bonding point, resulting in an increased bonding strength between an inner lead and an electrode, which ensures that an inner lead is not prone to be peeled off an electrode.

### BRIEF DESCRIPTION OF THE DRAWINGS

Fig. 1 is a plan view partially illustrating a conventional semiconductor device where an inner lead is bonded to an electrode at a single bonding point.

Fig. 2 is a plan view partially illustrating a semiconductor device in accordance with the first embodiment of the present invention.

Fig. 3 is a cross-sectional view taken along the line III-III in Fig. 2.

Fig. 4 is a plan view partially illustrating a semiconductor device in accordance with the second embodiment of the present invention.

### DESCRIPTION OF THE PREFERRED EMBODIMENTS

### [First Embodiment]

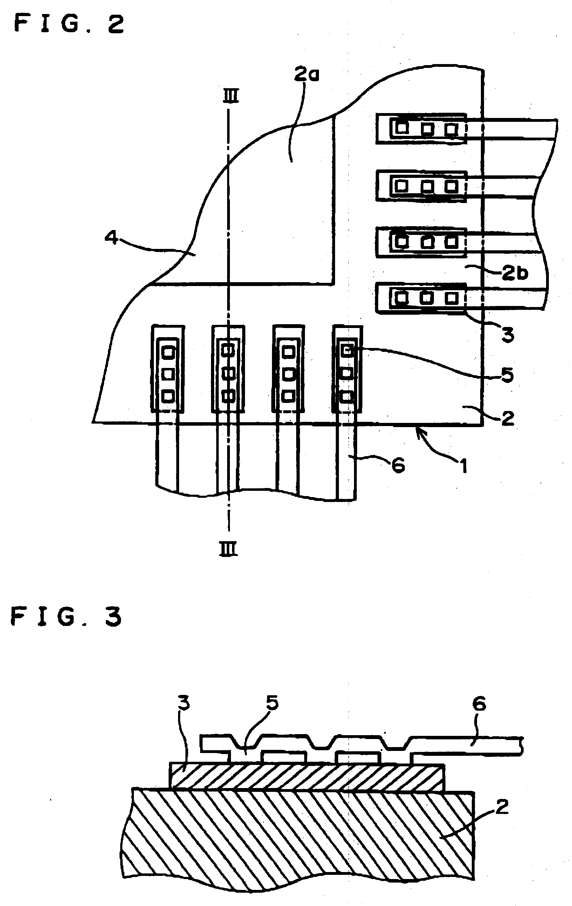

Fig. 2 illustrates a semiconductor device in accordance with the first embodiment. Fig. 3 illustrates a cross-section of an inner lead bonded to an electrode.

The illustrated semiconductor device 1 includes a semiconductor substrate 2 having a central area 2a in which an integrated circuit 4 is formed, and a marginal area 2b around the central area 2a. In the marginal area 2b, a plurality of electrodes 3 is formed in a line.

The electrodes 3 are all formed rectangular in shape. Each of the rectangular electrodes 3 has a longer side extending perpendicularly to an edge of the semiconductor substrate 2. As illustrated in Figs. 2 and 3, each of inner leads 6 is bonded to each of the electrodes 3 at three bonding points 5 arranged in a length-wise direction of the electrode 3. The three bonding points 5 are equally spaced away from adjacent ones.

Since the inner leads 6 are bonded to the electrodes 3 at the three bonding points 5, a bonding strength between the inner lead 6 and the electrode 3 can be enhanced relative to a bonding strength obtained by a conventional structure where an inner lead is bonded to an electrode at a single boding point.

The number of the bonding points 5 is not to be limited to three. The inner leads 6 may be bonded to the electrodes 3 at two bonding points, or at four bonding points or greater.

Though the bonding points 5 are equally spaced away from adjacent ones in the first embodiment, it is not always necessary to do so. The bonding points 5 may be irregularly spaced away from adjacent ones.

### [Second Embodiment]

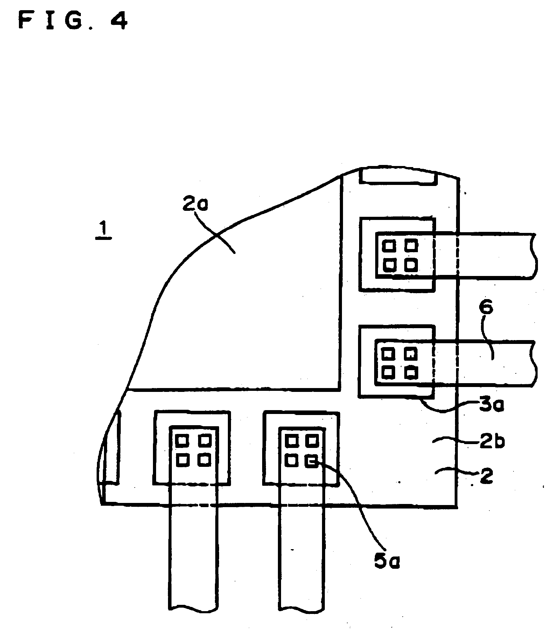

Fig. 4 illustrates a semiconductor device in accordance with the second embodiment.

The illustrated semiconductor device 1 includes a semiconductor substrate 2 having a central area 2a in which an integrated circuit 4 is formed, and a marginal area 2b around the central area 2a. In the marginal area 2b, a plurality of electrodes 3a is formed in a line.

The electrodes 3a are all formed square in shape. As illustrated in Fig. 4, each of inner leads 6 is bonded to each of the square electrodes 3a at four bonding points 5a arranged in a grid, or in a square. The four bonding points 5a are equally spaced away from adjacent ones.

Since the inner leads 6 are bonded to the electrodes 3a at the four bonding points 5a, a bonding strength between the inner lead 6 and the electrode 3a can be enhanced relative to a bonding strength obtained by a conventional structure where an inner lead is bonded to an electrode at a single boding point.

Similarly to the first embodiment, the number of the bonding points 5a is not to be limited to four. The inner leads 6 may be bonded to the electrodes 3a at five bonding points or greater, unless the bonding points are arranged in a grid.

An area of one bonding point is dependent on a bonding tool by which an inner lead is bonded to an electrode, and is usually small relative to an area of an electrode. However, by bonding an inner lead to an electrode at a plurality of bonding points, it is possible to considerably increase a bonding area and hence a bonding strength between an inner lead and an electrode without using a particular bonding tool.

## Claims

1. A semiconductor device comprising: (a) a semiconductor substrate (2); (b) at least one electrode (3, 3a) formed on the semiconductor substrate (2); and (c) an inner lead (6) bonded to the electrode (3, 3a),
characterized by that the inner lead (6) is bonded to the electrode (3, 3a) at a plurality of bonding points (5, 5a).

2. The semiconductor device as set forth in claim 1, wherein the electrode (3) is shaped a rectangle having a longer side perpendicular to an edge of the semiconductor substrate (2), and wherein the bonding points (5) are arranged in a longitudinal direction of the electrode (3).

3. The semiconductor device as set forth in claim 2, wherein the bonding points (5) are equally spaced away from adjacent ones.

4. The semiconductor device as set forth in claim 1, wherein the electrode (3a) is shaped a square, and wherein the bonding points (5a) are arranged in a grid.

5. A structure of bonding an inner lead (6) to an electrode (3, 3a) formed on a semiconductor substrate (2), characterized by a plurality of bonding points (5, 5a) at which said inner lead (6) is bonded to said electrode (3, 3a).

6. The structure as set forth in claim 5, wherein said bonding points (5) are arranged in a line extending perpendicularly to an edge of said semiconductor substrate (2).

7. The structure as set forth in claim 5, wherein said electrode (3a) is a square in shape, and wherein said bonding points (5a) are arranged in a grid.

8. A method of bonding an inner lead (6) to an electrode (3, 3a) in a semiconductor device (1), characterized by the step of bonding an inner lead (6) to an electrode (3, 3a) at a plurality of bonding points (5, 5a).

9. The method as set forth in claim 8, wherein the bonding points (5) are arranged in a line extending perpendicularly to an edge of a semiconductor substrate (2).

10. A method of bonding an inner lead (6) to an electrode (3a) in a semiconductor device (1), characterized by the step of bonding an inner lead (6) to a square electrode (3a) at a plurality of bonding points (5a) arranged in a grid.
